# EUROPEAN PATENT APPLICATION

(11) **EP 2 511 395 A2**
(43) Date of publication of application: **17.10.2012**
(21) Application number: 12163927.2
(22) Date of filing: 12.04.2012
(51) Int. Cl.: C23C 14/12, C23C 14/24, C23C 14/26, C23C 14/54, H05B 33/10

(54) **Depositing apparatus for forming thin film**

(30) Priority: 13.04.2011 KR 20110034338
(71) Applicant: SNU Precision Co., Ltd., Asan-si Chungcheongnam-do 336-871 (KR)
(72) Inventor: Cho, Whang Sin, 122-819 Seoul (KR); Song, Ki Chul, 305-805 Daejeon (KR); Jung, Seung Chul, 302-861 Daejeon (KR); Ahn, Woo Jung, 463-030 Gyeonggi-do (KR)
(74) Representative: Chaillot, Denis Vincent

(57) **Abstract**

Disclosed is a depositing apparatus for forming a thin film, the apparatus including a source container in which a source material to be deposited on a substrate is accommodated in a solid or liquid state; an evaporation chamber which couples and communicates with the source container above the source container, and through which an evaporated source material from the source container passes; a spraying hole which is formed on a top of the evaporation chamber, and sprays upward the evaporated source material passed through the evaporation chamber; a first heater which is provided above the source material inside the evaporation chamber or the source container, and supplies heat to the source material to evaporate the source material accommodated in the source container; and a block plate which is provided above the first heater inside the evaporation chamber, and prevents the source material or foreign materials contained in the source container from being sputtered and attached to the spraying hole while the first heater supplies heat to the source material.

## Description

### CROSS-REFERENCE TO RELATED APPLICATION

This application claims priority to and the benefit of Korean Patent Application No. 10-2011-0034338 filed in the Korean Intellectual Property Office on April 13, 2011, the entire contents of which are incorporated herein by reference.

### BACKGROUND OF THE INVENTION

### (a) Field of the Invention

The present invention relates to a depositing apparatus for forming a thin film, and more particularly to a depositing apparatus for forming a thin film, in which an organic substance can be evaporated and deposited on a substrate in the form of a thin film.

### (b) Description of the Related Art

An organic light emitting device is a next-generation display device that can emit light in itself, which is excellent in a viewing angle, contrast, response speed, power consumption, etc. as compared with those of a liquid crystal display (LCD) device.

The organic light emitting device includes organic light emitting diodes connected between scan lines and data lines as a matrix type and forming pixels. The organic light emitting diode includes an anode, a cathode, and an organic thin film layer formed between the anode and the cathode and having a hole transport layer, an organ light emitting layer and an electron transport layer. When a predetermined voltage is applied between the anode and the cathode, holes injected from the anode and electrons injected from the cathode are recombined in the light emitting layer, while emitting light based on energy difference.

An organic substance, used in a deposition process for the organic thin film layer to manufacture the organic light emitting device, does not require a high vapor pressure and is easily broken-down and denatured at high temperature on the contrary to an inorganic substance. Due to such material properties, a source container made of a tungsten material is filled with an organic substance and heated to evaporate the organic substance, thereby depositing a conventional organic thin film on a substrate.

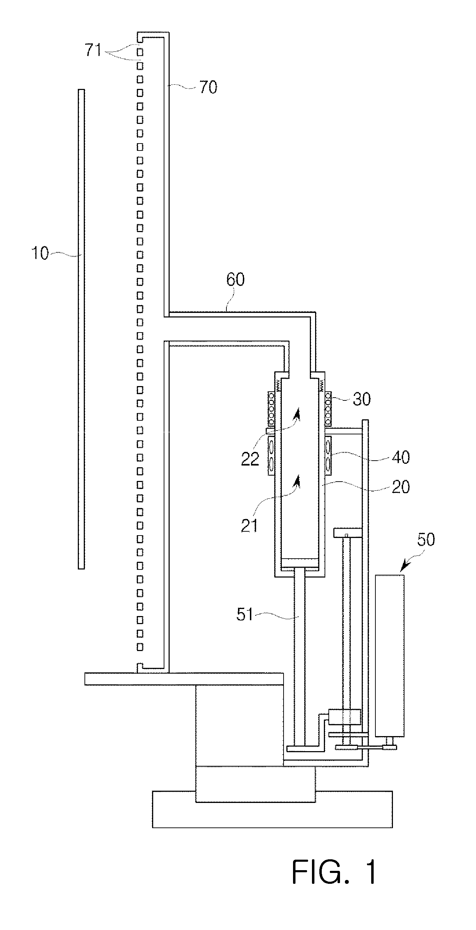

Fig. 1 shows an example of a conventional depositing apparatus for forming a thin film.

Referring to Fig. 1, the conventional depositing apparatus for forming a thin film is configured to deposit a source material to a substrate 10 supported in a vertically direction. Further, the conventional depositing apparatus includes a source container 20 shaped like a cylindrical pipe and internally divided into a storage space 21 at a lower side to be filled with a source material and an evaporation space 22 at an upper side where the source material is evaporated; a heater 30 for heating the source material in the source container 20; and a cooler 40 for cooling the source material so that the source material filled in the storage space 21 can be prevent from denaturalization.

Also, the conventional depositing apparatus for forming a thin film includes a cylinder head 51 for lifting up the source material; a transfer unit 50 for transferring the cylinder head 51; a connection pipe 60 for guiding the evaporated source material to an injector 70; and a spraying hole 71 for spraying the evaporated source material in a horizontal direction.

However, the amount of deposition sources, which the source container is capable of storing, is limited, and therefore there arises problems in that the source material for the deposition has to be frequently refilled and on all such occasions the depositing apparatus for forming a thin film should be shut down.

Meanwhile, a method of injecting the source material upward has been proposed, but it has problems that the source material is attached to and clogs the spraying hole, and thus the source material is not sprayed toward the substrate, thereby causing defective products. In this case, the spraying hole on which the source material is accumulated has to be replaced with a new one or cleaned while production is suspended, and then the production can be resumed. Accordingly, there is an inevitable problem that a decrease in production is caused by the suspended production.

Also, if the evaporated materials are accumulated on the spraying hole or internal parts or operating units, it may not only have an effect on the performance of the parts and units but also damage the parts and units in severe cases. Particularly, the more the source material is used, the more such phenomenon becomes severe.

### SUMMARY OF THE INVENTION

Accordingly, the present invention is conceived to solve the forgoing problems, and an aspect of the present invention is to provide a depositing apparatus for forming a thin film, in which a block plate for preventing a source material sputtered from a source container or foreign materials from being attached to a spraying hole is provided inside an evaporation chamber so that the source material can be stably and continuously evaporated; the source material is stably evaporated through direct temperature control to make uniform deposition and large area deposition be possible; and continuous production is possible for a long time without suspending the production.

In accordance with an exemplary embodiment of the present invention, there is provided a depositing apparatus for forming a thin film, the apparatus including a source container in which a source material to be deposited on a substrate is accommodated in a solid or liquid state; an evaporation chamber which couples and communicates with the source container above the source container, and through which an evaporated source material from the source container passes; a spraying hole which is formed on a top of the evaporation chamber, and sprays upward the evaporated source material passed through the evaporation chamber; a first heater which is provided above the source material inside the evaporation chamber or the source container, and supplies heat to the source material to evaporate the source material accommodated in the source container; and a block plate which is provided above the first heater inside the evaporation chamber, and prevents the source material or foreign materials contained in the source container from being sputtered and attached to the spraying hole while the first heater supplies heat to the source material.

The block plate may be shaped like a flat plate, and spaced apart at a predetermined distance from an inner wall of the evaporation chamber.

The apparatus may further include a second heater provided on the top or lateral sides of the evaporation chamber, and supply heat to the evaporation chamber to prevent the evaporated source material passing through the evaporation chamber from phase change into a liquid or solid state.

The source container may be detachably coupled to the evaporation chamber.

The apparatus may further include a transfer unit for transferring the source material in a direction of getting close to the first heater or getting away from the first heater.

The apparatus may further include a sensor provided in the evaporation chamber and sensing the amount of evaporated source material passing through the evaporation chamber.

The apparatus may further include a transfer unit which transfers the source material in a direction of getting close to the first heater or getting away from the first heater; a sensor which is provided in the evaporation chamber and senses the amount of evaporated source material passing through the evaporation chamber; and a controller which gets feedback on the amount of evaporated source material from the sensor, and if the amount of evaporated source material is less than a preset reference amount, transmits a signal to the transfer unit so that the source material can be transferred in a direction of getting close to the first heater or transmits a signal for increasing temperature of the first heater, and if the amount of evaporated source material is more than the preset reference amount, transmits a signal to the transfer unit so that the source material can be transferred in a direction of getting away from the first heater or transmitting a signal for decreasing temperature of the first heater.

As described above, the depositing apparatus for forming a thin film according to an exemplary embodiment of the present invention prevents a source material sputtered up from the source container or foreign materials from being attached to the spraying hole, and makes continuous production possible for a long time without suspending the production.

Also, in the depositing apparatus for forming a thin film according to an exemplary embodiment of the present invention, a temperature reaction of the source material in the source container can be quickly achieved by temperature control of the first heater; a desired target temperature for the source material in the source container can be constantly maintained without large variation; and the source material can be stably evaporated to thereby achieve uniform deposition and large area deposition.

Further, the depositing apparatus for forming a thin film according to an exemplary embodiment of the present invention can prevent the evaporated source material passing through the evaporation chamber from phase change into a liquid or solid state, and prevent the evaporated source material remained without being deposited on the substrate from being attached to and clogging up the spraying hole.

Additionally, in the depositing apparatus for forming a thin film according to an exemplary embodiment of the present invention, the amount of source material evaporated from the source container is controlled by adjusting a distance between the source material and the first heater or the temperature of the first heater, thereby stably maintaining the amount of evaporated source material.

### BRIEF DESCRIPTION OF THE DRAWINGS

The above and/or other aspects of the present invention will become apparent and more readily appreciated from the following description of the exemplary embodiments, taken in conjunction with the accompanying drawings, in which:
Fig. 1 shows an example of a conventional depositing apparatus for forming a thin film;
Fig. 2 is a schematic view of a depositing apparatus for forming a thin film according to an exemplary embodiment of the present invention;
Fig. 3 is a view showing that a source material is transferred in a direction of getting away from a first heater in the depositing apparatus of Fig. 2 for forming a thin film;
Fig. 4 is a schematic view showing an alternative example of the depositing apparatus of Fig. 2 for forming a thin film; and
Fig. 5 is a schematic view showing another alternative example of the depositing apparatus of Fig. 2 for forming a thin film.

### DETAILED DESCRIPTION OF THE EMBODIMENTS

Hereinafter, exemplary embodiments of a depositing apparatus for forming a thin film according to the present invention will be described with reference to accompanying drawings.

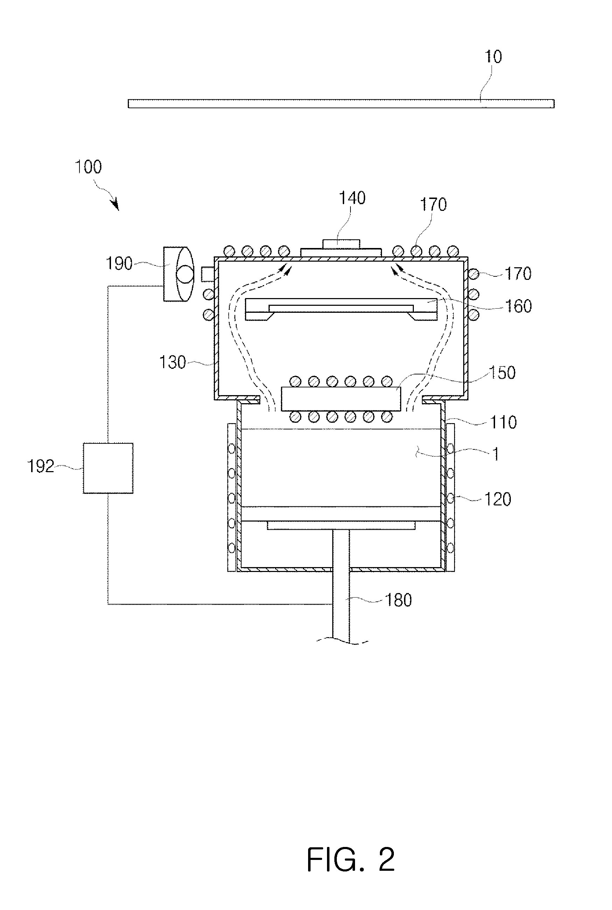

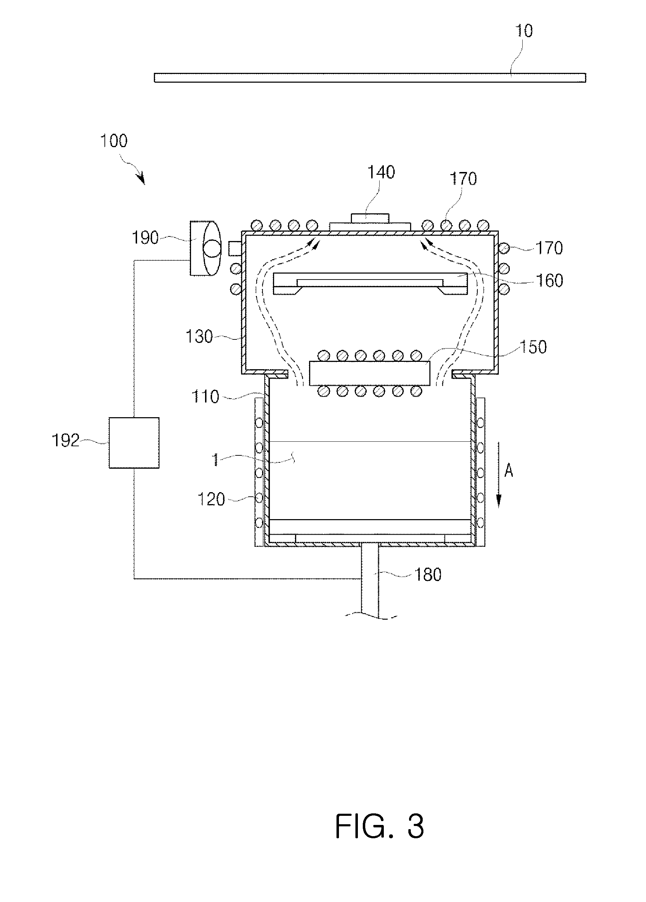

Fig. 2 is a schematic view of a depositing apparatus for forming a thin film according to an exemplary embodiment, and Fig. 3 is a view showing that a source material is transferred in a direction of getting away from a first heater in the depositing apparatus of Fig. 2 for forming a thin film.

Referring to Figs. 2 and 3, the depositing apparatus for forming a thin film in this exemplary embodiment, which is an apparatus capable of evaporating an organic substance and depositing it in the form of a thin film on a substrate, includes a source container 110, a cooler 120, an evaporation chamber 130, a spraying hole 140, a first heater 150, a block plate 160, a second heater 170, a transfer unit 180, a sensor 190 and a controller 192.

The present invention provides an apparatus for manufacturing an organic light emitting device (OLED), in which a source material used in exemplary embodiments may be an organic substance by way of an example.

The source container 110, in which the source material 1 to be deposited on the substrate 10 is accommodated in a solid or liquid state, is shaped like a cylinder opened at one side. Generally, the source container 110 is made of a tungsten material, and filled with the organic substance as the source material 1 to be deposited on the substrate 10.

At this time, the source container 110 may connect with a vacuum line (not shown) for keeping the inside of the source container 110 under a vacuum pressure condition while performing a deposition process. The source material 1 is denaturalized under high temperature and pressure in the source container 110. To prevent the source material 1 from the denaturalization, the temperature and pressure in the source container 110 has to be kept low. Also, the evaporation point of the source material 1 is much affected by the degree of a vacuum. Since the evaporation point is tend to lower as the degree of a vacuum decreases, the degree of a vacuum kept low in the source container 110 is more efficient in preventing the source material from denaturalization.

The cooler 120 cools the source material 1 accommodated in the source container 110 in order to prevent the source material 1 accommodated in the source material 110 from being denaturalized by heat from the first heater 150 (to be described later). The cooler 120 is configured to surround an outer wall of the source container 110.

The cooler 120 may be achieved by in various forms capable of cooling the inside of the source container 110 filled with the source material 1. In this exemplary embodiment, a cooling jacket is used for example. The cooler 120 is configured by surrounding the outer circumference of the source container 110 with a cooling channel in which a coolant flows.

The evaporation chamber 130, which provides a space through which the evaporated source material 1 from the source container 110 passes, is coupled to and communicates with the source container 110 at an upper side of the source container 110. The source material 1 accommodated in the source container 110 as the solid or liquid state is heated by the first heater 150 to be described later, and the heated source material 1 gasified and vaporized upward. The evaporated source material 1 is introduced into the evaporation chamber 130 arranged above the source container 110, and then passes through the evaporation chamber 130, so that the evaporated material 1 can be sprayed toward the substrate 10 via the spraying hole 140 (to be described later).

The evaporation chamber 130 has a volume large enough to accommodate a considerable amount of evaporated source material 1. As the source material 1 evaporated from the source container 110 is sufficiently accommodated in the evaporation chamber 130, the amount of source material sprayed toward the substrate 10 via the spraying hole 140 can be stably maintained. The evaporation chamber 130 is formed to have a sufficient inner space, and thus serves as a kind of accumulator.

The evaporation chamber 130 is detachably coupled to the source container 110. When the source material 1, i.e., the organic substance to be deposited on the substrate 10 is filled in the source container 110, the deposition process is suspended and the source container 110 is separated from the evaporation chamber 130. Thereafter, if the source material 1 is completely filled in the source container 110, the source container 110 is coupled again to the evaporation chamber 130 and the deposition process is resumed.

In the case where various kinds of organic thin films are sequentially stacked, a plurality of source containers 110 are respectively provided to correspond to a plurality of organic substances, and the source container 110 accommodating the organic substance to be used in each deposition process is selected and mounted to the evaporation chamber 130.

The spraying hole 140, which is an opening for spraying the evaporated source material 1 passed through the evaporation chamber 130 upward, i.e., toward the substrate 10, is formed on the top of the evaporation chamber. The spraying hole 140 is aligned in a breadth direction of the substrate 10 and faces the substrate 10.

The spraying hole 140 may be manufactured as a separate part in the form of a nozzle and coupled to the evaporation chamber 130, and may be integrally formed as a through hole on an upper wall of the evaporation chamber 130.

The first heater 150, which supplies heat to the source material 1 so as to evaporate the source material 1 accommodated in the source container 110, is installed inside the evaporation chamber 130 or above the source material 1 inside the source container 110.

The first heater 150 may have various shapes as long as it can supply thermal energy for evaporating the source material 1. For instance, a core heater, a lamp heater or the like may be employed. In this exemplary embodiment, the core heater is used as the first heater 150. The first heater 150 is achieved by winding a resistive hot wire around a plate inside the evaporation chamber 130. At this time, the resistive hot wire may contain Ta, W, Mo or alloy thereof.

Conventionally, the heater for supplying heat to the source material accommodated in the source container is generally installed in an outer wall of the source container. However, in this exemplary embodiment, the first heater 150 is installed in the same space as that for the source material 1, so that the heat from the first heater 150 can be directly transferred to the source material 1 without a medium. Accordingly, a temperature reaction of the source material 1 can be quickly achieved by temperature control of the first heater 150, and a desired target temperature for the source material 1 can be constantly maintained without large variation.

The block plate 160 prevents that the source material 1 accommodated in the source container 110 or foreign materials are sputtered and attached to the spraying holes 140 while the first heater 150 supplies heat to the source container 1.

While the source material 1 is heated by the first heater 150, the gasified source material 1 is normally vaporized from the surface of the liquid source material 1. However, the liquid source material may be suddenly splashed or the foreign materials mixed in the source material 1 may be suddenly spattered.

As the sputtered source material 1 or foreign materials are attached to the spraying hole 140, there arises a problem of clogging the spraying hole 140. If the spraying hole 140 is clogged, the process has to be suspended for replacing it with a new one or cleaning the spraying hole 140 and then resumed. In this case, a yield of the apparatus is decreased.

Thus, the block plate 160 blocks the source material 1 or foreign materials that are not evaporated but sputtered and attached to the spraying hole 140, and makes continuous production possible for a long time, thereby increasing the yield of the apparatus.

Meanwhile, heat from a top of the block plate may be transferred to the source material 1 through a communicated path. In this case, the amount of evaporating the source material 1, control of which is based on a distance between the first heater 150 and the source material 1 or the temperature of the first heater 150, may be varied depending on an unexpected external factor. Change in the amount of evaporating the source material 1 directly affects the thickness of an organic light emitting diode, and causes a defective product.

Therefore, the block plate 160 is used to fully intercept heat being transferred from the outside to the source material 1, thereby eliminating the external factors that may affect the amount of evaporating the source material 1.

The block plate 160 is shaped like a flat plate and installed inside the evaporation chamber 130, and arranged above the first heater 150. Also, the block plate 160 is spaced apart at a predetermined distance from an inner wall of the evaporation chamber 130, so that the evaporated source material can pass through a space between the block plate 160 and the inner wall of the evaporation chamber 130 and move toward the spraying hole 140.

The second heater 170, which supplies heat to the evaporation chamber 130 in order to prevent the evaporated source material 1 passing through the evaporation chamber 130 from phase change into the liquid or solid state, is installed on the top and lateral sides of the evaporation chamber 130.

Likewise, the second heater 170 may employ the core heater, the lamp heater, or the like, and the resistive hot wire used at this time may contain Ta, W, Mo or alloy thereof.

The second heater 170 prevents a phenomenon that the evaporated source material 1 is not deposited on the substrate 10 but attached to and clogging the spraying hole 140. The evaporated source material 1 remained in the evaporation chamber is accumulated at a side of the spraying hole 140 and thus results in clogging the spraying hole 140 through the phase change into the solid state. Therefore, the second heater 170 increases the temperature around the spraying hole 140 so that the source material around the spraying hole 140 can be always maintained in a gasified state.

The transfer unit 180 reciprocates the source material 1 in a direction of getting close to the first heater 150 or getting away from the first heater 150. The transfer unit 180 is used to adjust the distance between the source material 1 and the first heater 150, thereby controlling the amount of source material 1 to be evaporated.

For example, if the evaporation amount of source material 1 is less than a preset reference amount, the source material 1 is transferred in the direction of getting close to the first heater 150 so that sufficient heat can be supplied from the first heater 150 to the source material 1, thereby increasing the evaporation amount of source material 1. On the other hand, if the evaporation amount of source material 1 is more than a preset reference amount, the source material 1 is transferred in the direction of getting away from the first heater 150 so that heat supplied from the first heater 150 to the source material 1 can be decreased, thereby decreasing the evaporation amount of source material 1.

The transfer unit 180 may be configured in various forms as long as it can have a linear reciprocation motion. For example, a pneumatic cylinder, a linear motor, combination of a rotary motor and a ball screw, and the like configuration well-known to those skilled in the art may be employed, and thus detailed descriptions thereof will be omitted.

The sensor 190 is installed in the evaporation chamber 130, and senses the amount of evaporated source material 1 passing through the evaporation chamber 130. In accordance with the amount of the evaporated source material 1 sensed by the sensor 190, the temperature of the first heater 150 and an operating direction or transferring speed of the transfer unit 180 are controlled to thereby adjust the amount of evaporated source material 1.

The controller 192 gets feedback on the amount of evaporated source material 1 from the sensor 190 and controls the first heater 150 or the transfer unit 180.

For example, if the evaporation amount of source material 1 is less than the reference amount, the controller 192 transmits a signal to the transfer unit 180 so that the source material 1 can be transferred in the direction of getting close to the first heater 150, or transmits a signal for increasing the temperature of the first heater 150, thereby increasing the evaporation amount of source material 1.

On the other hand, if the evaporation amount of source material 1 is more than the reference amount, the controller 192 transmits a signal to the transfer unit 180 so that the source material 1 can be transferred in the direction of getting away from the first heater 150, or transmits a signal for decreasing the temperature of the first heater 150, thereby decreasing the evaporation amount of source material 1.

As described above, the depositing apparatus for forming a thin film according to an exemplary embodiment of the present invention prevents a source material sputtered up from the source container or foreign materials from being attached to the spraying hole, and makes continuous production possible for a long time without suspending the production.

Also, the depositing apparatus for forming a thin film according to an exemplary embodiment of the present invention, the heat is directly transferred from the first heater to the source material without a medium, so that a temperature reaction of the source material can be quickly achieved by temperature control of the first heater; a desired target temperature for the source material can be constantly maintained without large variation; and the source material can be stably evaporated to thereby achieve uniform deposition and large area deposition.

Further, the depositing apparatus for forming a thin film according to an exemplary embodiment of the present invention includes the second heater installed in the top and lateral sides of the evaporation chamber and supplying heat to the evaporation chamber, so that the evaporated source material passing through the evaporation chamber can be prevented from phase change into a liquid or solid state, and the evaporated source material remained without being deposited on the substrate can be prevented from being attached to and clogging up the spraying hole.

Additionally, in the depositing apparatus for forming a thin film according to an exemplary embodiment of the present invention, the amount of source material evaporated from the source container is controlled by adjusting a distance between the source material and the first heater or the temperature of the first heater, thereby stably maintaining the amount of evaporated source material.

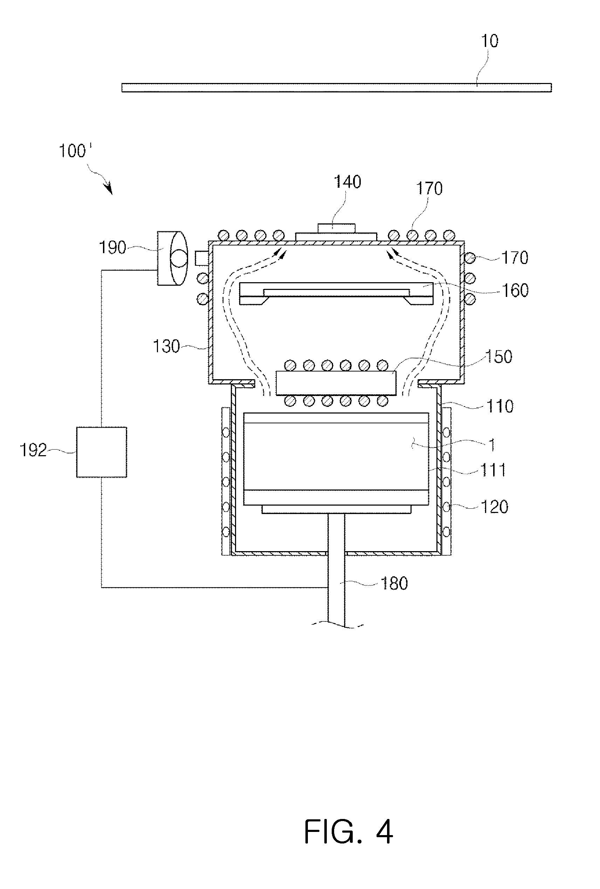

Fig. 4 is a schematic view showing an alternative example of the depositing apparatus of Fig. 2 for forming a thin film.

Referring to Fig. 4, a depositing apparatus 100' for forming a thin film includes an additional crucible 111 inside the source container 110. In the case of a liquid source material, it may leak downward while being transferred by the transfer unit. Accordingly, a separate crucible is provided for accommodating the source material, thereby preventing the source material from leaking and contaminating the transfer unit.

In Fig. 4, elements have the same configuration and functions as those of elements referred to by the same numerals shown in Figs. 2 and 3, and thus detailed descriptions thereof will be omitted.

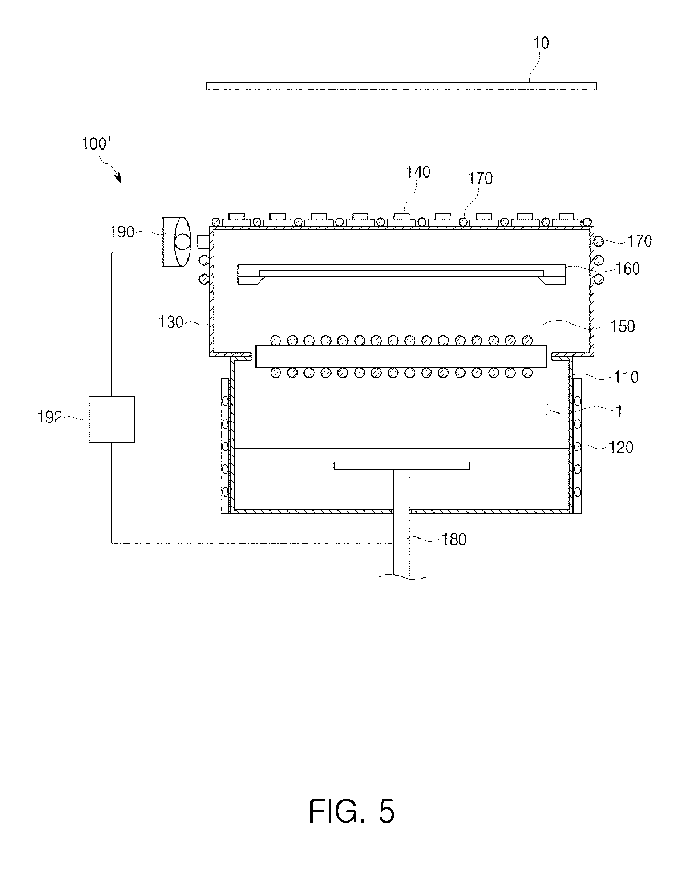

Fig. 5 is a schematic view showing another alternative example of the depositing apparatus of Fig. 2 for forming a thin film.

Referring to Fig. 5, a depositing apparatus 100" for forming a thin film includes a plurality of spraying holes 140, thereby stably and uniformly deposition the source material on a large-area substrate 10. In Fig. 5, elements have the same configuration and functions as those of elements referred to by the same numerals shown in Figs. 2 and 3, and thus detailed descriptions thereof will be omitted.

Although a few exemplary embodiments of the present invention have been shown and described, it will be appreciated by those skilled in the art that changes may be made in these embodiments without departing from the principles and spirit of the invention, the scope of which is defined in the appended claims and their equivalents.

## Claims

1. A depositing apparatus (100) for forming a thin film, the apparatus comprising
a source container (110) in which a source material (1) to be deposited on a substrate (10) is accommodated in a solid or liquid state;
an evaporation chamber (130) which couples and communicates with the source container (110) above the source container (110), and through which an evaporated source material from the source container (110) passes;
a spraying hole (140) which is formed on a top of the evaporation chamber (130), and sprays upward the evaporated source material passed through the evaporation chamber (130);
a first heater (150) which is provided above the source material (1) inside the evaporation chamber (130) or the source container (110), and supplies heat to the source material (1) to evaporate the source material (1) accommodated in the source container (110); and
a block plate (160) which is provided above the first heater (150) inside the evaporation chamber (130), and prevents the source material (1) or foreign materials contained in the source container (110) from being sputtered and attached to the spraying hole (140) while the first heater (150) supplies heat to the source material (1).

2. The apparatus according to claim 1, wherein the block plate (160) is shaped like a flat plate, and spaced apart at a predetermined distance from an inner wall of the evaporation chamber (130).

3. The apparatus according to claim 1, further comprising a second heater (170) provided on the top or lateral sides of the evaporation chamber (130), and supplying heat to the evaporation chamber (130) to prevent the evaporated source material passing through the evaporation chamber (130) from phase change into a liquid or solid state.

4. The apparatus according to claim 1, wherein the source container (110) is detachably coupled to the evaporation chamber (130).

5. The apparatus according to claim 1, further comprising a transfer unit (180) for transferring the source material (1) in a direction of getting close to the first heater (150) or getting away from the first heater (150).

6. The apparatus according to claim 1, further comprising a sensor (190) provided in the evaporation chamber (130) and sensing the amount of evaporated source material passing through the evaporation chamber (130).

7. The apparatus according to claim 1, further comprising:
a transfer unit (180) which transfers the source material (1) in a direction of getting close to the first heater (150) or getting away from the first heater (150);
a sensor (190) which is provided in the evaporation chamber (130) and senses the amount of evaporated source material passing through the evaporation chamber (130); and
a controller (192) which gets feedback on the amount of evaporated source material from the sensor (190), and if the amount of evaporated source material is less than a preset reference amount, transmits a signal to the transfer unit (180) so that the source material (1) can be transferred in a direction of getting close to the first heater (150) or transmits a signal for increasing temperature of the first heater (150), and if the amount of evaporated source material is more than the preset reference amount, transmits a signal to the transfer unit (180) so that the source material (1) can be transferred in a direction of getting away from the first heater (150) or transmitting a signal for decreasing temperature of the first heater (150).
